# EUROPÄISCHE PATENTANMELDUNG

(11) **EP 4 425 370 A1**
(43) Veröffentlichungstag der Anmeldung: **04.09.2024**
(21) Anmeldenummer: 23158983.9
(22) Anmeldetag: 28.02.2023
(51) Int. Cl.: G06K 7/10, G01N 21/00, G01R 31/00

(54) **ELEKTRONISCHE BAUGRUPPE MIT HOCHFREQUENZ-REFLEKTOMETRIE-IDENTIFIKATION**

(71) Anmelder: Siemens Aktiengesellschaft, 80333 München (DE)
(72) Erfinder: SANTOS WILKE, Hans, 85599 Parsdorf (DE); RAAB, Oliver, 94496 Ortenburg (DE); STEGMEIER, Stefan, 81825 München (DE); MITIC, Gerhard, 81827 München (DE); MAYER, Lukas Walter, 1190 Wien (AT)
(74) Vertreter: Siemens Patent Attorneys

(57) **Zusammenfassung**

Verfahren und Anordnung zur Identifizierung einer elektronischen Baugruppe (10), bei dem ein charakteristischer Datensatz der elektronischen Baugruppe (10) mittels Hochfrequenz-Reflektometrie aufgenommen wird, wobei eine reproduzierbare Positionierung der zu identifizierenden Baugruppe (10) zur Hochfrequenz-Reflektometrie-Messvorrichtung (20, 21) erfolgt.

## Beschreibung

Die Erfindung betrifft ein Verfahren zur Identifizierung einer elektronischen Baugruppe sowie eine elektronische Baugruppe.

Ein weltweit auftretendes Problem auf dem Markt mit elektronischen Bauteilen, insbesondere leistungselektronischen Baugruppen ist der bisher wenig vorhandene Fälschungs- und Manipulationsschutz für derartige Produkte. Dies ist zum einen für die Kunden der Produkte ein Problem und auch für den Hersteller. Insbesondere sind Fälschungen oder Manipulationen von Produkten nur sehr schwer zu erkennen und noch schwerer nachweisbar. Bisher sind derartige Nachweise einer Fälschung nur mit sehr hohem Aufwand, wenn überhaupt, realisierbar und in der Regel für den Kunden selbst nicht leistbar.

Neben der Fälschung stellt auch die Manipulation, z. B. schadhafte Manipulation derartiger Produkte eine Rolle. Eine solche Manipulation kann ohne Wissen von Hersteller oder Kunde vorgenommen werden. Beispielsweise könnten Chips, deren Software und deren Daten ausgelesen werden. Es könnte sogar passieren, dass ganze Chips getauscht werden, den Chips absichtlich oder unabsichtlich Schaden zugefügt wird. Aber auch die Erkennung unabsichtlich entstehender Schäden an Chip und/oder Bauteil sind nur sehr schwierig erkennbar und nachweisbar.

Besonders kritisch ist dies innerhalb der Fertigung von industriell komplexen Produkten, welche teils über mehrere Jahre bis hin zu Jahrzehnten bei einem Endkunden funktionieren müssen, z. B. im Bereich von leistungselektronischen Ansteuerungen. In solchen Produkten muss unbedingt vermieden werden, dass eine schadhafte Komponente mitverbaut wird oder eine Manipulation durchgeführt werden kann. Dies könnte vor allem für einen Endkunden weitreichende und schwerwiegende Folgen haben.

Bisher wird im Bereich von Fälschungsschutz von elektronischen Baugruppen mit Sicherheitssiegeln mit Hologramm und Muster gearbeitet. Seriennummern, Logos oder Geschmacksmuster kennzeichnen Produkte.

Elektronikprodukte wie beispielsweise PCs werden mittels zusätzlicher Chips abgesichert, beispielsweise dem Trusted Platform Module. Für die Absicherung der Schlüssel für kryptografische Verfahren werden aktuell beispielsweise Physical unclonable functions verwendet.

Einzelne Komponenten einer Baugruppe können gegenüber Manipulationen beispielsweise mittels Vergusses geschützt werden, d. h. die einzelne Komponente ist zumindest vor versehentlich mechanischer Beschädigung geschützt. Neben Vergussverfahren sind auch Schutzfolien bekannt, die um ein zu schützendes System gewickelt werden. Die Unversehrtheit des Systems wird bisher beispielsweise mit Hilfe einer eingebetteten elektrischen Schaltung überprüft, wie beispielsweise aus https://www.ims.fraunhofer.de/de/Geschaeftsfelder/ASICS/Anwen dungen/MAVO-COPYCAT.html bekannt.

In der Elektronikforschung wird auch ein Fälschungsschutz beschrieben, der Elektronikbaugruppen anhand von Mikroskopbildern einen Fingerprint zuordnet, beispielsweise aus dem Projekt Track-4-Quality, https://www.elektronikforschung.de/projekte/track-4-qualityonikforschung, bekannt.

Ausgehend vom zuvor beschriebenen Stand der Technik liegt der Erfindung die Aufgabe zugrunde, ein verbessertes Verfahren anzugeben, mit dem für elektronische Baugruppen, insbesondere für leistungselektronische Baugruppen, ein Fälschungs- und Manipulationsschutz gewährleistet wird. Ebenso besteht eine Aufgabe darin, eine elektronische Baugruppe anzugeben, welche für ein derart verbessertes Identifikationsverfahren geeignet ist.

Diese Aufgabe wird durch die Merkmale des unabhängigen Anspruchs 1 gelöst. Die auf die Vorrichtung bezogene Aufgabe wird durch die Merkmale des unabhängigen Patentanspruchs 13 gelöst. Darüber hinaus wird eine Anordnung zur Durchführung des erfindungsgemäßen Verfahrens im unabhängigen Patentanspruch 7 angegeben. Vorteilhafte Ausgestaltungen der Erfindung sind Gegenstand der Unteransprüche.

Das erfindungsgemäße Verfahren zur Identifizierung einer elektronischen Baugruppe, insbesondere einer leistungselektronischen Baugruppe, umfasst die Aufnahme eines charakteristischen Datensatzes der elektronischen Baugruppe mittels Hochfrequenz-Reflektometrie, wobei eine reproduzierbare Positionierung anhand von Backscatter-Elementen erfolgt. Dieses Verfahren hat den Vorteil eine Charakterisierung und anschließend reproduzierbare Identifizierung der elektronischen Baugruppe zu gewährleisten. Die Positionierung anhand von Backscatter-Elementen ist sehr viel genauer als eine mechanische Positionierung. Der charakteristische Datensatz beinhaltet eine erforderliche Mindestdatenmenge sowie eine Mindestauflösung zur eindeutigen Identifizierung der elektronischen Baugruppe. Insbesondere sind Mindestauflösungen der Datenmenge so groß gewählt, dass bei dem charakteristischen Datensatz von einem digitalen Fingerprint der elektronischen Baugruppe gesprochen werden kann.

Insbesondere handelt es sich bei dem charakteristischen Datensatz um ein dreidimensionales topologisches Bild, welches mittels der Hochfrequenz-Reflektometrie aufgenommen wird. In einer bevorzugten Variante des erfindungsgemäßen Verfahrens umfasst dazu die Messvorrichtung eine bewegliche Einheit, welche für die Aufnahme des charakteristischen Datensatzes eine ein- oder zweidimensionale Rasterbewegung über die gesamte Fläche der elektronischen Baugruppe ausführt. Die Aufnahme eines derartigen dreidimensionalen topologischen Bildes führt zu sehr eindeutigen Fingerprints der Baugruppen, welche bevorzugt mittels Bilderkennungsverfahren gespeichert, abgeglichen und kategorisiert werden.

In einer weiteren vorteilhaften Ausführungsform der Erfindung wird bei dem Verfahren eine bewegliche Einheit eingesetzt, welche ein Array von mindestens zwei Hochfrequenzantennen aufweist. Dies hat u. a. den Vorteil, ein noch höherwertigeres, genaueres und demnach eindeutigeres dreidimensionales Bild zu erstellen.

In einer weiteren vorteilhaften Ausführungsform der Erfindung umfasst das Identifizierungsverfahren nach der Erstellung des dreidimensionalen topologischen Bildes der Baugruppe auch dessen Speicherung, insbesondere zusammen mit der Seriennummer, sodass Baugruppe, Seriennummer und charakteristischer Datensatz eindeutig einander zuordenbar sind.

Speichert man die so gewonnenen Daten einer jeden Baugruppe vor Auslieferung an den Kunden gemeinsam mit der Seriennummer ab, kann dessen Echtheit und Originalität eindeutig und jederzeit nachgewiesen werden. Dieser Fingerabdruck ist dabei fälschungssicher, da er sowohl intrinsisch als auch verschleiert ist: er ist nach außen weder sichtbar, noch ist er ohne entsprechend passendes Equipment auslesbar.

In einer weiteren vorteilhaften Ausgestaltung des erfindungsgemäßen Verfahrens dient eine Hochfrequenzantenne wechselweise als Sender und als Empfänger. Insbesondere erfolgt eine Berechnung der Wegstrecke anhand der gemessenen Signallaufzeiten. Durch Berechnung der Wegstrecke entsteht zunächst ein eindimensionales ortsaufgelöstes Datenraster des zu charakterisierenden Moduls oder der zu charakterisierenden Baugruppe. Durch das Abrastern der Baugruppe entsteht dann die 3D-topologische Information. Besonders bevorzugt ist dieses Verfahren auf sämtliche Flachbaugruppen mit elektronischen Komponenten, insbesondere Leiterplatten anwendbar.

Die der Erfindung zugrundeliegende Aufgabe wird des Weiteren durch eine Anordnung gelöst, welche zur Aufnahme eines Identifizierungsmerkmals einer elektronischen, insbesondere einer leistungselektronischen Baugruppe ausgestaltet ist. Diese Anordnung umfasst eine Hochfrequenz-Reflektometrie-Messvorrichtung, welche eine bewegliche Einheit umfasst, die derart beweglich zur elektronischen Baugruppe angeordnet ist, dass eine ein- oder zweidimensionale Rasterbewegung über die gesamte Fläche der elektronischen Baugruppe ausführbar ist. Insbesondere kann die Rasterbewegung über ausgewählte Teilbereiche der elektronischen Baugruppe erfolgen, bevorzugt wird die gesamte Fläche der elektronischen Baugruppe aufgenommen. Besonders geeignet ist das Verfahren demnach für Flachbaugruppen. Alternativ können auch gezielt gewählte Rasterwege abgefahren werden, um die Identifizierung noch zusätzlich zu individualisieren.

Zweckdienlicherweise werden in der Anordnung elektronische, insbesondere leistungselektronische Baugruppen charakterisiert, welche Backscatter-Elemente aufweisen. Diese Backscatter-Elemente gewährleisten eine reproduzierbare Positionierung relativ zur Messvorrichtung. Dies hat den Vorteil, dass die Messungen zur Wiedererkennung und Identifizierung zuverlässig reproduziert werden können.

In einer vorteilhaften Ausgestaltung der Erfindung umfasst die erfindungsgemäße Anordnung beispielsweise eine bewegliche Einheit, welche ein Array von mindestens zwei Hochfrequenzantennen umfasst. Bevorzugt wird für jede Rasterrichtung ein Array von mehreren Hochfrequenzantennen genutzt, um die zu identifizierende Baugruppe mittels Hochfrequenz-Reflektometrie abzubilden. Notwendig sind dazu mindestens zwei Einzelantennen, vorteilhaft sind jeweils zweidimensionale Anordnungen mehrerer Antennen auf die Baugruppe gerichtet. Bevorzugt werden 2D-Anordnungen von Antennen als sogenannte Linienarrays verwendet.

Beim Abrastern der Modulfläche dient dabei jede Antenne wechselweise sowohl als Sender als auch Empfänger für die Hochfrequenzwellen. Insbesondere werden Radarwellen eingesetzt. Aus den Signallaufzeiten werden Wegstrecken berechnet und daraus ein zunächst eindimensionales ortsaufgelöstes Datenraster des Moduls erstellt, welches die topologischen Informationen der gesamten Baugruppe enthält. Mit einem zweidimensionalen Antennenarray und/oder mit der Abrasterbewegung lässt sich daraus ein zweidimensional ortsaufgelöstes Datenraster des Moduls erstellen. Der Datensatz enthält also Informationen zur dreidimensionalen Position der Komponenten der Baugruppe. Daraus lassen sich insbesondere Bilder in unterschiedlichen Ebenen rekonstruieren.

Besonders vorteilhaft umfasst die erfindungsgemäße Anordnung in einer Ausführungsform eine Führungsvorrichtung für eine relative reproduzierbare ein- oder zweidimensionale Rasterbewegung über eine Fläche der elektronischen Baugruppe, insbesondere der leistungselektronischen Baugruppe. Dies kann insbesondere eine Schienenvorrichtung für die Antennenarrays sein. Die Führungsvorrichtung ist dazu bevorzugt höchst präzise einstellbar, da die zu vermessende Baugruppe reproduzierbar zur initialen Fingerabdrucknahme vermessen werden können muss.

In besonders vorteilhaften Ausführungsformen umfasst die Anordnung eine Hochfrequenz-Reflektometrie-Messvorrichtung, welche ein Array einer eindimensionalen Anordnung von mindestens zwei Hochfrequenzantennen umfasst, besonders bevorzugt ein Array einer 2D-Anordnung von mindestens zwei Hochfrequenzantennen. Mit mehreren Antennen zu Arrays wird die Empfindlichkeit mit der Hochfrequenz-Reflektometrie-Messvorrichtung gegenüber topologischen Veränderungen auf der Baugruppe erhöht.

In einer weiteren vorteilhaften Ausführungsform der Erfindung umfasst die erfindungsgemäße Anordnung zur Aufnahme eines Identifizierungsmerkmals einer elektronischen Baugruppe eine Datenverbindung zu einem Speichermodul zur Speicherung des charakteristischen Datensatzes zusammen mit der Seriennummer.

Die erfindungsgemäße elektronische Baugruppe, insbesondere ein leistungselektronischer Schaltungsträger, ist ausgestaltet in einem Verfahren gemäß der Erfindung so eingesetzt zu werden, dass eine die elektronische Baugruppe eindeutig charakterisierender Datensatz erstellt werden kann. Dazu weist die erfindungsgemäße elektronische Baugruppe bevorzugt wenigstens ein Backscatter-Element auf, bevorzugt zwei, besonders vorteilhaft drei Backscatter-Elemente. Unter einem Backscatter-Element, es kann ein passives Backscatter-Element oder ein aktives Backscatter-Element sein, ist ein Rückstreuelement zu verstehen, welches die Aufgabe erfüllt, die Radarstrahlung oder die eingesetzte Hochfrequenzstrahlung als Referenzsignal so zurück zu spielen, dass ein eindeutiges Referenzsignal seitens der zu identifizierenden Baugruppe an die Messvorrichtung erfolgt, um eine exakte Ausrichtung der Baugruppe zu gewährleisten. Besonders zuverlässig ist ein Referenzsignal von drei auf der Baugruppe verteilt angeordneten Backscatter-Elementen zu erhalten, wodurch ein ungewünschtes Verschieben des Radarsystems relativ zur Baugruppe vermieden wird. Passive Backscatter-Elemente können beispielsweise in die Leiterplatte eingebrachte resonante Strukturen sein. Diese liegen bevorzugt in der Größenordnung der verwendeten Hochfrequenzwellenlänge. Als aktives Backscatter-Element kann beispielsweise eine in die Leiterplatte integrierte Antenne verwendet werden, welche insbesondere an ein modulierendes Element angeschlossen sein kann, z. B eine PIN-Diode. Das Verfahren kann alternativ auch zur Identifikation einzelner Bauteile herangezogen werden.

Im Folgenden wird die Erfindung anhand der in den Figuren dargestellten Ausführungsbeispielen näher beschrieben und erläutert:
Figur 1 zeigt ein Array von Hochfrequenzantennen und eine Flachbaugruppe,
Figur 2 zeigt ein ortsaufgelöstes Datenraster XY-Ebene der Flachbaugruppe, welche 3D-topolgische Informationen (Graustufen) enthält, den intrinsischen 3D-Fingerabdruck der Flachbaugruppe.
Figur 3 zeigt den 3D-Fingerabdruck der Flachbaugruppe nach baulicher, aber augenscheinlich nicht sichtbarer Veränderung.

In den Ausführungsbeispielen und Figuren können gleiche oder gleich wirkende Elemente jeweils mit den gleichen Bezugszeichen versehen sein. Die dargestellten Elemente und deren Grö-ßenverhältnisse untereinander sind grundsätzlich nicht als maßstabsgerecht anzusehen, vielmehr können einzelne Elemente, zur besseren Darstellbarkeit, im Verhältnis größer dimensioniert dargestellt sein.

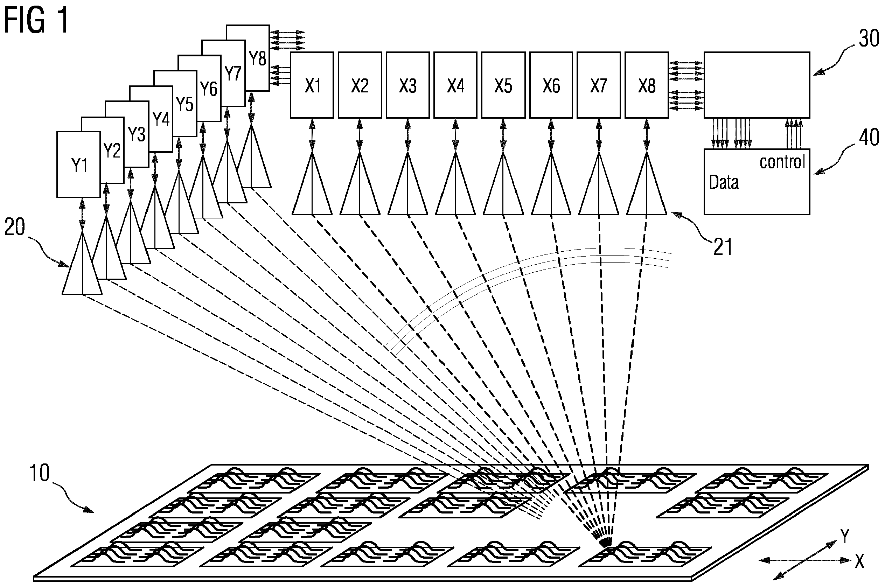

In der Figur 1 ist eine elektronische Baugruppe 10 als Flachbaugruppe dargestellt. Mit Pfeilen entlang der flächigen Ausdehnung der Baugruppe 10 sind die X- und Y-Rasterbewegungen dargestellt. Von der Messvorrichtung sind die Antennenarrays 20 und 21 mit jeweils acht Antennen gezeigt, welche in X-Richtung X1 bis X8 sowie in Y-Richtung Y1 bis Y8 linear angeordnet sind. Die einzelnen Antennen 20, 21 sind jeweils als Sender und Empfänger ausgestaltet. Das Rückstrahlsignal wird entsprechend Position und Laufzeit ausgewertet. Das reflektierte Signal wird bevorzugt an eine Auswerteeinheit 30 weitergeleitet und von dort das berechnete charakteristische dreidimensionale topologische Bild der Baugruppe 10 an eine Speichereinheit 40 weitergegeben. Insbesondere kann auch eine Steuereinrichtung control umfasst sein, welche insbesondere bei der Justage bzw. Positionierung der Baugruppe relativ zur Messvorrichtung eingesetzt werden kann.

Kommt es aufgrund von Fertigungstoleranzen bei der Herstellung einer elektronischen Baugruppe 10 zu Unterschieden zwischen den Baugruppen, was im Grunde jedes Modul, selbst wenn baugleich hergestellt, einzigartig macht, kann man entsprechend auch einen intrinsischen 3D-Fingerabdruck eines jeden Moduls erhalten. Je mehr einzelne Komponenten auf einer Baugruppe enthalten sind, desto spezifischer ist dieser 3D-Fingerabdruck.

Speichert man diesen charakteristischen Datensatz mit den so aus den reflektierten und verrechneten Radarsignalen erhaltenen Identifikationsdatensatz einer jeden Baugruppe vor ihrer Auslieferung an einen Kunden zusammen mit ihrer Seriennummer ab, kann die Echtheit und Originalität einer jeden Baugruppe eindeutig und jederzeit nachgewiesen werden. Ein derartig erstellter Fingerabdruck in Form eines charakteristischen Datensatzes ist dabei fälschungssicher, da er sowohl intrinsisch als auch verschleiert ist. Er ist nach außen weder sichtbar noch ohne passendes Equipment auslesbar. Die Aufnahme des Identifikationsdatensatzes sowie dessen Überprüfung erfolgt über eine Mess- und Auswertevorrichtung, welche bevorzugt als externes Modul zur Verfügung steht.

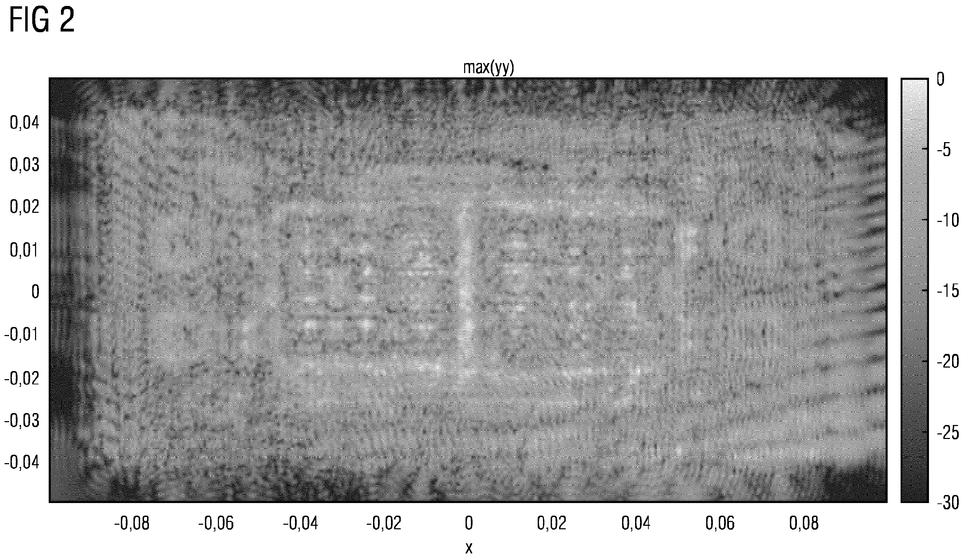

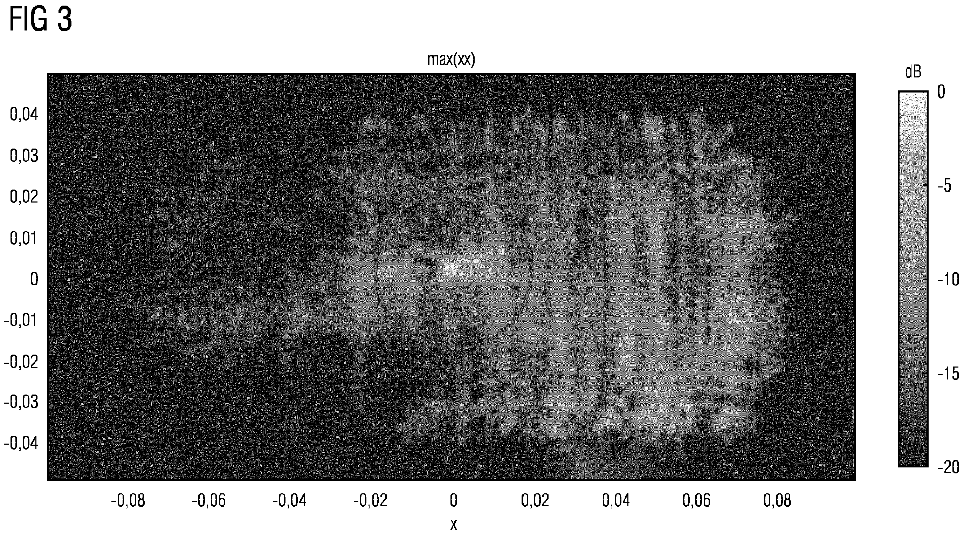

Verfahren und Anordnung haben den Vorteil neben einem Fälschungsschutz auch einen Manipulationsschutz zu gewährleisten. Mittels der Hochfrequenz-Reflektometrie können Differenzbilder desselben Bauteils erstellt und verglichen werden. In den Figuren 2 und 3 sind die topologischen Fingerabdrücke desselben Bauteils gezeigt, welches zwischen den beiden Aufnahmen verändert wurde. Das Verfahren offenbar auch Veränderungen an einer Baugruppe 10, welche augenscheinlich nicht sichtbar sind. Solche Veränderungen können beispielsweise eine leichte Umbiegung eines Bonddrahts sein. Derartige schadhafte Veränderungen der Baugruppe können durch Manipulation, aber auch durch versehentliche Schäden am Bauteil entstehen.

Die Einzigartigkeit eines derartigen Datensatzes, eines derartigen 3D-topologischen Fingerabdrucks, einer Baugruppe ist jedem derartigen elektronischen Bauteil inhärent. Dies hat den großen Vorteil, dass auf der Baugruppe kein zusätzlicher kostenintensiver Chip notwendig wird. Der Schutz vor und die Detektion von Manipulationen ist dadurch mit einfachen Sicherheitsmerkmalen gewährleistet. Das Verfahren mit der Radarbildaufnahme betrachtet bevorzugt die gesamte Platine und nicht nur einzelne Elemente davon. Zugleich wird nicht nur angezeigt, dass eine Veränderung erfolgte, auch der Ort der Manipulation auf dem Bauteil kann lokalisiert angezeigt werden, sodass eine mutmaßliche Manipulation gezielt genauer untersucht werden kann.

Zudem kommt noch der Vorteil hinzu, dass ein Hochfrequenz-Reflektometrie-Signal sehr komplex und kaum zu verfälschen ist. Das Signal ist bereits durch kleinste Änderungen in der Bauteillösung beeinflussbar.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

Zusammenfassend kann festgehalten werden, dass der vorgeschlagene Fälschungs- und Manipulationsschutz ein dreidimensionales topologisches Bild einer Baugruppe als einen intrinsischen fälschungssicheren Fingerabdruck verwendet. Die Aufnahme des dreidimensionalen topologischen Bildes erfolgt mittels Hochfrequenz-Reflektometrie. Die so erhaltenen charakteristischen Daten sind für jedes einzelne damit charakterisierte Modul spezifisch. Demnach kann ein einmal auf diese Art charakterisiertes Modul immer wieder identifiziert werden.

Wichtig für die zuverlässige Identifikation eines so charakterisierten Bauteils ist die reproduzierbare Messung: dazu weist die zu charakterisierende Baugruppe mindestens ein, bevorzugt drei Backscatter-Elemente auf. Die Vermessung einer Baugruppe mittels HF-Reflektometrie ist sehr empfindlich gegenüber topologischen Veränderungen auf der Baugruppe, allerdings auch gegenüber der Ausrichtung des Sende- und Empfängermoduls relativ zur Baugruppe. Mittels Referenzsignalen kann eine exakte Positionierung der Baugruppe relativ zur Messvorrichtung vor Beginn der Identifikationsmessung vorgenommen werden. Referenzsignale von bevorzugt drei verteilten Backscatter-Elementen auf der Baugruppe erlauben die Korrektur von unerwünschten Verschiebungen des Radarsystems relativ zur Baugruppe.

### Bezugszeichenliste:

10 leistungselektronische Baugruppe, insbesondere Flachbaugruppe
20 Antennen-Array
21 Antennen-Array
30 Auswerteeinheit
40 Speicher, Datenspeicher, Prozessor, Steuerungseinrichtung x-Achse-Rasterrichtung
y-Achse-Rasterrichtung

## Patentansprüche

1. Verfahren zur Identifizierung einer elektronischen Baugruppe (10), bei dem ein charakteristischer Datensatz der elektronischen Baugruppe (10) mittels Hochfrequenz-Reflektometrie aufgenommen wird, wobei eine reproduzierbare Positionierung der zu identifizierenden Baugruppe (10) zur Hochfrequenz-Reflektometrie-Messvorrichtung (20, 21) erfolgt.

2. Verfahren nach Anspruch 1, bei dem die Hochfrequenz-Reflektometrie-Messvorrichtung eine bewegliche Einheit umfasst, welche eine ein- oder zweidimensionale Rasterbewegung über die gesamte Fläche der elektronischen Baugruppe (10) ausführt.

3. Verfahren nach Anspruch 2, bei dem die bewegliche Einheit ein Array von mindestens zwei Hochfrequenzantennen (20, 21) umfasst.

4. Verfahren nach einem der vorstehenden Ansprüche, wobei der charakteristische Datensatz (Data) der Baugruppe (10) zusammen mit der Seriennummer abgespeichert wird, so dass die Baugruppe (10) diesem eindeutig zugeordnet werden kann.

5. Verfahren nach einem der vorstehenden Ansprüche, wobei eine Hochfrequenzantenne (20, 21) wechselweise als Sender und als Empfänger dient.

6. Verfahren nach einem der vorstehenden Ansprüche, umfassend eine Berechnung (30) der Wegstrecke anhand gemessener Signallaufzeiten.

7. Anordnung zur Aufnahme eines charakteristischen Datensatzes als Identifizierungsmerkmals einer elektronischen Baugruppe (10), umfassend eine Hochfrequenz-Reflektometrie-Messvorrichtung, welche eine bewegliche Einheit umfasst, die derart beweglich zur elektronischen Baugruppe (10) angeordnet ist, dass eine ein- oder zweidimensionale Rasterbewegung (x, y) über eine Fläche der elektronischen Baugruppe (10) ausführbar ist.

8. Anordnung nach Anspruch 7, wobei die bewegliche Einheit der Messvorrichtung ein Array von mindestens zwei Hochfrequenzantennen (20, 21) umfasst.

9. Anordnung nach einem der Ansprüche 7 oder 8, umfassend eine Führungsvorrichtung für eine relative reproduzierbare ein- oder zweidimensionale Rasterbewegung (x, y) über eine Fläche der elektronischen Baugruppe (10).

10. Anordnung nach einem der Ansprüche 7 bis 9, wobei das Array eine 1D-Anordnung von mindestens zwei Hochfrequenzantennen (20, 21) umfasst.

11. Anordnung nach Anspruch 7 bis 10, wobei das Array eine 2D-Anordnung von mindestens zwei Hochfrequenzantennen (20, 21) umfasst.

12. Anordnung nach Anspruch 7 bis 11, umfassend eine Datenverbindung zu einem Speichermodul (40) zur Speicherung des charakteristischen Datensatzes einer elektronischen Baugruppe (10) zusammen mit deren Seriennummer.

13. Elektronische Baugruppe (10), insbesondere leistungselektronische Baugruppe, welche ausgestaltet ist, in einem Verfahren nach einem der vorhergehenden Ansprüche 1 bis 6 eingesetzt zu werden, aufweisend wenigstens 1 Backscatter-Element, insbesondere 2 oder 3 Backscatter-Elemente.

14. Elektronische Baugruppe (10) nach Anspruch 13, umfassend passive Backscatter-Elemente.

15. Elektronische Baugruppe (10) nach Anspruch 13, umfassend aktive Backscatter-Elemente.
